# EUROPÄISCHE PATENTANMELDUNG

(11) **EP 0 768 719 A2**
(43) Veröffentlichungstag der Anmeldung: **16.04.1997**
(21) Anmeldenummer: 96116077.7
(22) Anmeldetag: 08.10.1996
(51) Int. Cl.: H01L 31/028, H01L 31/0216, C07C 13/00

(54) **Passivierung von Fullerenen**

(30) Priorität: 09.10.1995 DE 19537550
(71) Anmelder: HOECHST AKTIENGESELLSCHAFT, 65929 Frankfurt am Main (DE)
(72) Erfinder: Fünffinger, Martin, 86441 Wörleschwang (DE); Henke, Sascha, Dr., 70193 Stuttgart (DE); Stritzker, Bernd, Prof. Dr., 86438 Kissing (DE)

(57) **Zusammenfassung**

Die Erfindung betrifft einen Körper, enthaltend Fullerene, der dadurch gekennzeichnet ist, daß die Fullerene von mindestens einer sauerstoffundurchlässigen Schicht bedeckt sind. Die Erfindung betrifft weiter ein Verfahren zum passivieren von derartigen Körpern, indem man die Körper mit einem sauerstoffundurchlässigen Material beschichtet.

Die Vorteile der Erfindung liegen darin, daß die Sauerstoffempfindlichkeit der Fullerene keine Rolle mehr spielt und daß dadurch die Fullerene technisch besser nutzbar werden, unter anderem in der Supraleitung und Optoelektronik.

## Beschreibung

Die Erfindung betrifft einen Formkörper, enthaltend Fullerene. Formkörper der genannten Art sind aus den Arbeiten von L. Palmetshofer et al. (J. Appl. Phys. 77 (3), 1. Febr. 1995) und Xiang-Dong Wang et al. (Applied Surface Science 76/77 (1994), 334 - 339) bekannt, die hierin per Bezugnahme integriert sind. In diesen Arbeiten wird ein Siliziumsubstrat beschrieben, auf das nach einem PVD-Verfahren (Physical Vapour Deposition) eine Fullerenschicht aufgebracht wurde.

Fullerene besitzen außergewöhnliche elektrische Eigenschaften. Sie sind unter anderem Halbleiter mit einer direkten Bandlücke von ca. 1,5 eV. Diese Eigenschaft kann zum Bau von Photodioden genutzt werden. Eine Änderung der Energielücke durch Dotierung mit Alkali- bzw. Erdalkalimetallatomen führt bei Temperaturen bis 33 K ("Sprungtemperatur") zur Supraleitung. Diese hohen Sprungtemperaturen und ihre dreidimensionale Leitung sind eine weitere außergewöhnliche Eigenschaft dieser Materialien.

Ein gewichtiger Nachteil für eine Anwendung dieser Schichtsysteme ist die hohe Sauerstoffempfindlichkeit der dotierten Fullerenschichten. Durch eindringenden Sauerstoff können die dotierten Metalle oxidiert werden, wodurch die Supraleitfähigkeit verschwindet. Eine Oxidation der Kohlenstoffatome selbst ist ebenfalls möglich. Aus diesem Grund sind solche Schichtsysteme technisch nur eingeschränkt nutzbar.

Der Erfindung lag daher die Aufgabe zugrunde, einen Formkörper der eingangs genannten Art bereitzustellen, mit dem die außergewöhnlichen Eigenschaften der Fullerene technisch besser genutzt werden können. Diese Aufgabe wird erfindungsgemäß dadurch gelöst, daß die Fullerene von sauerstoffundurchlässigem Material umgeben sind.

Gegenstand der Erfindung ist somit ein Formkörper, enthaltend Fullerene, der dadurch gekennzeichnet ist, daß die Fullerene von sauerstoffundurchlässigem Material umgeben sind.
Wesentlich ist dabei, daß die Fullerene vollständig vom Luftsauerstoff abgeschirmt sind. Bevorzugte Ausgestaltungen des erfindungsgemäßen Formkörpers ergeben sich aus den Ansprüche 2 bis 9.

Eine bevorzugte Ausgestaltung des erfindungsgemäßen Formkörpers ist dadurch gekennzeichnet, daß die Fullerene als Schicht auf einem Substrat, das vorzugsweise aus einer Keramik oder aus einem Metall oder einem Kunststoff oder einem Mineral besteht, vorliegen und das Substrat ganz oder teilweise bedecken. Als Mineral kann vorteilhafterweise Glimmer verwendet werden. In einer besonderen Ausgestaltung liegt das sauerstoffundurchlässige Material in Form einer sauerstoffundurchlässige Schicht vor.

Eine weitere Ausgestaltung zeichnet sich dadurch aus, daß die sauerstoffundurchlässige Schicht ein Sauerstoffgettermaterial, vorzugsweise Aluminium, Titan, Tantal, Chrom, besonders bevorzugt Aluminium, oder amorphen Kohlenstoff enthält. Die sauerstoffundurchlässige Schicht kann 50 bis 2000 nm, vorzugsweise 100 bis 1000 nm, besonders bevorzugt 200 bis 500 nm dick sein.

Eine weitere Ausgestaltung ist dadurch gekennzeichnet, daß die sauerstoffundurchlässige Schicht ein Oxid enthält, vorzugsweise Aluminiumoxid, Titanoxid, Chromoxid oder Tantaloxid, besonders bevorzugt Aluminiumoxid. Schichten aus den genannten Oxiden können wenige, vorzugsweise 2 bis 10 Nanometer dick sein. In einer weiteren Ausgestaltung sind die Fullerene mit Alkali- oder Erdalkalimetallen, vorzugsweise Barium, dotiert. Ein derartiger dotierter Formkörper kann bei Temperaturen kleiner als - 200 bis - 240°C Supraleitfähigkeit aufweisen. Die Dotierung mit Barium kann über eine Beschichtung durch ein PVD-Verfahren bei einer Temperatur bis 250°C und anschließendem Tempern bei einer Temperatur von 100 bis 400°C erfolgen. In einer besonderen Ausgestaltung ist das Substrat ein Draht. Als Drahtmaterial eignen sich die gängigen Werkstoffe, vorzugsweise Kupfer oder Aluminium. Ein solcher Draht eignet sich zur Herstellung elektronischer Bauteile.

In einer weiteren besonderen Ausgestaltung des erfindungsgemäßen Formkörpers weist ein Draht eine supraleitende Fullerenschicht auf, die von zwei elektrisch isolierenden Schichten umgeben ist, beispielsweise um Kurzschlüsse mit dem Drahtwerkstoff zu vermeiden. Die Schichten können aus unterschiedlichen Materialien wie Kunststoff oder Keramik bestehen.

Gegenstand der Erfindung ist weiter ein Verfahren zum Passivieren von Körpern enthaltend Fullerene, das dadurch gekennzeichnet ist, daß man die Körper mit sauerstoffundurchlässigem Material beschichtet. Besondere Ausführungsformen dieses Verfahrens ergeben sich aus den Ansprüchen 10 bis 14.

Eine besondere Ausführungsform des erfindungsgemäßen Verfahrens ist dadurch gekennzeichnet, daß die Beschichtung mit Aluminium durch ein PVD-Verfahren bei einer Temperatur aus dem Bereich von 100 bis 450°C erfolgt. Eine Beschichtung durch ein CVD-Verfahren (Chemical Vapour Deposition) ist ebenfalls möglich.

Da die Topographie solcher Schichten von der Depositionsrate (Einheit nm/s) und der Substrattemperatur abhängt, ist es für eine gute Passivierung vorteilhaft, beide Parameter aufeinander abzustimmen, damit die Dichte an Al-Atomen innerhalb der sauerstoffundurchlässigen Schicht gleichmäßig sehr hoch ist. Das ist bei einer hohen Depositionsrate und einer niedrigen Substrattemperatur der Al-Atome der Fall. Die Depositionsrate sollte größer sein als 0,2 nm/s, vorzugsweise größer als 0,4 nm/s. Die Substrattemperatur sollte kleiner sein als 150°C, vorzugsweise kleiner als 100°C. Al-Schichten, die auf diese Weise hergestellt wurden, bilden eine dichte Oberflächenschicht aus Aluminiumoxid aus, die mit dazu beiträgt, ein Eindringen weiterer Sauerstoffatome unmöglich zu machen. In analoger Weise kann auch ein Draht beschichtet werden.

Es können auch einzelne oder mehrere der in den Sach- bzw. Verfahrensansprüchen beschriebenen Einzelmerkmale jeweils für sich eigenständige erfindungsgemäße Lösungen bilden und es sind auch die Merkmale innerhalb der Anspruchskategorien beliebig kombinierbar.

Der Vorteil der Erfindung ist im wesentlichen darin zu sehen, daß sie es ermöglicht, Fullerene beispielsweise in der Supraleitung technisch zu nutzen und optoelektrische Bauteile mit Fullerenen herzustellen, da sich die Sauerstoffempfindlichkeit reiner oder dotierter Fullerenschichten nicht mehr nachteilig auswirkt.

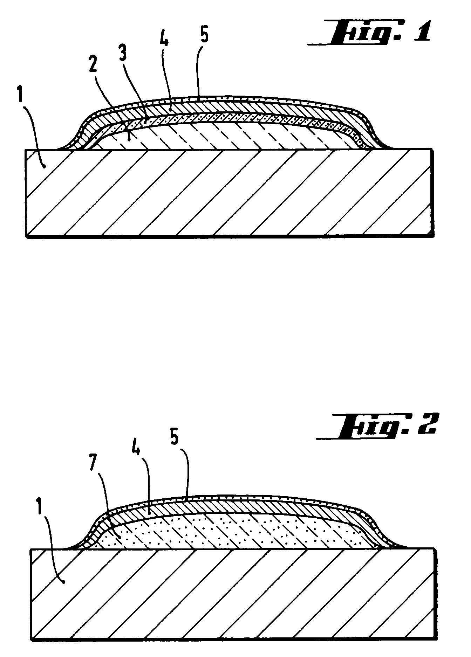

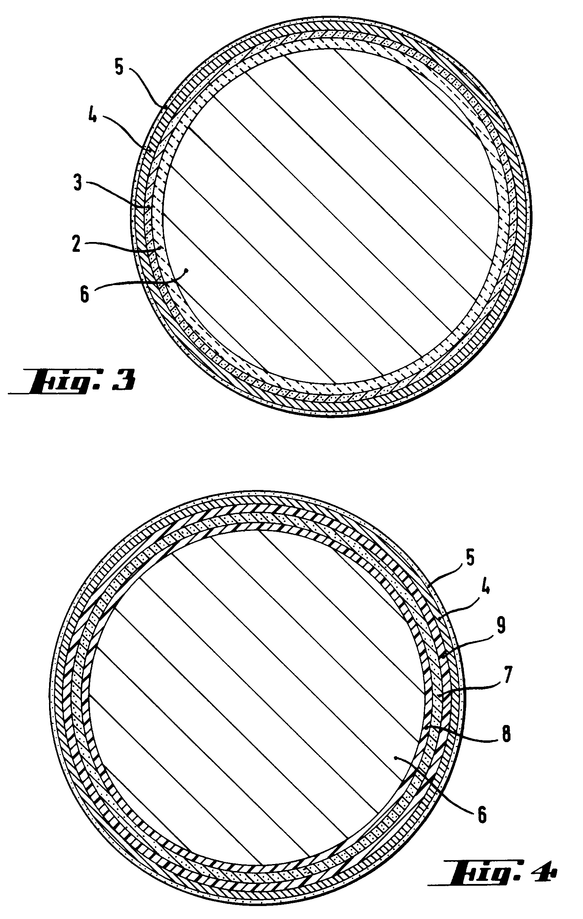

Im folgenden werden vier mögliche Beispiele eines erfindungsgemäßen Körpers und eine mögliche Ausführungsform des erfindungsgemäßen Verfahrens unter Bezugnahme auf die Figuren 1 bis 4 näher beschrieben, ohne die Erfindung dadurch auf die Beispiele zu beschränken.

Es zeigt
- Fig. 1: eine Schnittansicht durch einen erfindungsgemäßen Formkörper, bestehend aus einem (Glimmer-)Substrat 1 mit einer Fullerenschicht 2, einer Ba-Schicht 3, einer Al-Schicht 4 und einer Al-Oxidschicht 5;
- Fig. 2: eine Schnittansicht durch einen erfindungsgemäßen Formkörper, bestehend aus einem (Glimmer-)Substrat 1 und einer BaₓC₆₀-Schicht 7, einer Al-Schicht 4 und einer Al-Oxidschicht 5;
- Fig. 3: eine Schnittansicht eines Drahtes (Dicke nicht maßstabsgerecht) mit einer Schichtfolge entsprechend Fig. 1;
- Fig. 4: eine Schnittansicht eines Drahtes (Dicke nicht maßstabsgerecht) mit einer supraleitenden Schicht 7, die von elektrisch isolierenden Schichten 8, 9 umgeben ist.

Auf ein Glimmer(001)-Substrat 1 wurde in an sich bekannter Weise (vgl. Palmetshofer et al., Xiang Dong Wang et al.) eine Schicht 2 aus C₆₀-Fulleren epitaktisch aufgebracht. Die Substrattemperatur betrug 50°C, die Depositionsrate 0,01 nm/s, die Schichtdicke 60 - 200 nm. Danach wurde auf die C₆₀-Schicht im Ultrahochvakuum und bei Raumtemperatur eine Bariumschicht 3 aufgedampft. Deren Schichtdicke wurde so gewählt, daß sich eine Stöchiometrie BaₓC₆₀ von 0<X<6 ergab. Die Depositionsrate betrug 0,05 nm/s.

Anschließend wurde der erhaltene Verbund bei einer Temperatur von 200°C 24 h getempert. Durch diese Wärmebehandlung gelang es, die C₆₀-Schicht mit Ba zu dotieren und es entstand eine BaₓC₆₀-Schicht 7.

Danach wurde dieses dotierte Schichtsystem passiviert, d.h. es wurde durch Elektronenstrahlverdampfung mit Aluminium beschichtet. Die Schichtdicke betrug 100 - 200 nm

Der Nachweis der erfolgreichen Passivierung wurde mit drei unterschiedlichen Methoden durchgeführt:

### (1) Ramanspektroskopie:

Die A_{g}(2)-Mode des C₆₀-Molekül bei einer Wellenzahl von 1469 cm⁻¹ wird durch die Anwesenheit von Sauerstoffatomen und bei gleichzeitiger Einstrahlung von Laserlicht gestört. Es bildet sich ein Triplettzustand aus, der zu einer Absenkung der Intensität der A_{g}(2)-Mode führt.

Eine Intensitätsveränderung der A_{g}(2)-Mode konnte an dotierten und undotierten Schichtsystemen, die mit einer Al-Schicht nach obigen Verfahren beschichtet wurden, auch bei Einstrahlung von hohen Laserintensitäten nicht beobachtet werden. Es ist somit zu keiner Reaktion zwischen Sauerstoffatomen- und C₆₀-Molekülen gekommen.

### (2) Rutherford-Backscattering-Spektroskopie (RBS):

Das Vorhandensein von Sauerstoffionen in einer Ba bzw. Baₓ-C₆₀-Schicht kann durch die Verschiebung der Sauerstoffkante geprüft werden. Außerdem ist es durch das Verfahren der Sauerstoffresonanz mit RBS bei hoher Empfindlichkeit möglich, niedrige Konzentrationen von Sauerstoffatomen zu bestimmen.

### (3) Optische Methode

Das Glimmersubstrat ist durchsichtig. Oxidiert die Ba-Schicht, bilden sich BaOxid-Körner, die eine weißgräuliche Farbe besitzen. Diese können, wenn sie groß genug sind, durch das Glimmersubstrat mit bloßem Auge beobachtet werden.

Bei den angegebenen Depositionsparametern war eine Oxidierung der Schichten mit den genannten Methoden nicht nachweisbar.

## Patentansprüche

1. Formkörper, enthaltend Fullerene, dadurch gekennzeichnet, daß die Fullerene von sauerstoffundurchlässigem Material umgeben sind.

2. Formkörper nach Anspruch 1, dadurch gekennzeichnet, daß das sauerstoffundurchlässige Material in Form einer sauerstoffundurchlässigen Schicht vorliegt.

3. Formkörper nach Anspruch 1 oder 2, dadurch gekennzeichnet, daß die Fullerene als Schicht auf einem Substrat, das vorzugsweise aus einer Keramik oder aus einem Metall oder einem Kunststoff oder einem Mineral besteht, vorliegen und das Substrat ganz oder teilweise bedecken.

4. Formkörper nach Anspruch 2 oder 3, dadurch gekennzeichnet, daß die sauerstoffundurchlässige Schicht ein Sauerstoffgettermaterial, vorzugsweise Aluminium, Titan, Tantal, Chrom, besonders bevorzugt Aluminium, oder amorphen Kohlenstoff enthält.

5. Formkörper nach Anspruch 2 oder 3 dadurch gekennzeichnet, daß die sauerstoffundurchlässige Schicht ein Oxid enthält, vorzugsweise Aluminiumoxid, Titanoxid, Chromoxid oder Tantaloxid, besonders bevorzugt Aluminiumoxid.

6. Formkörper nach einem oder mehreren der Ansprüche 2 bis 5, dadurch gekennzeichnet, daß die sauerstoffundurchlässige Schicht 50 bis 2000 nm, vorzugsweise 100 bis 1000 nm, besonders bevorzugt 200 bis 500 nm dick ist.

7. Formkörper nach einem oder mehreren der Ansprüche 1 bis 6, dadurch gekennzeichnet, daß die Fullerene mit Alkali- oder Erdalkalimetallen, vorzugsweise mit Barium, dotiert sind.

8. Formkörper nach Anspruch 7, dadurch gekennzeichnet, daß die Fullerenschicht bei Temperaturen kleiner als -200°C Supraleitfähigkeit hat.

9. Formkörper nach Anspruch 3, dadurch gekennzeichnet, daß das Substrat ein Draht ist.

10. Verfahren zum Passivieren von Formkörpern enthaltend Fullerene, dadurch gekennzeichnet, daß man die Körper mit sauerstoffundurchlässigem Material beschichtet.

11. Verfahren nach Anspruch 10, dadurch gekennzeichnet, daß das sauerstoffundurchlässige Material ein Sauerstoffgettermaterial oder ein Oxid enthält, vorzugsweise Aluminium, Chrom, Titan oder Tantal oder Alumoniumoxid, Chromoxid, Titanoxid oder Tantaloxid, besonders bevorzugt Aluminium oder Aluminiumoxid.

12. Verfahren nach Anspruch 11, dadurch gekennzeichnet, daß die Beschichtung mit Aluminium durch ein PVD-Verfahren bei einer Temperatur aus dem Bereich von 100 bis 450°C erfolgt.

13. Verfahren nach Anspruch 11 oder 12, dadurch gekennzeichnet, daß die Beschichtung mit einer Depositionsrate größer als 0,2 nm/s, vorzugsweise größer als 0,4 nm/s durchgeführt wird.

14. Verfahren nach einem oder mehreren der Ansprüche 11 bis 13, dadurch gekennzeichnet, daß die Beschichtung bei einer Substrattemperatur kleiner als 150°C, vorzugsweise kleiner als 100°C durchgeführt wird.

15. Verwendung von Formkörpern nach einem oder mehreren der Ansprüche 1 bis 9 zur Herstellung von elektrischen oder optoelektronischen Bauteilen.
